# EUROPEAN PATENT APPLICATION

(11) **EP 4 020 724 A1**
(43) Date of publication of application: **29.06.2022**
(21) Application number: 20884831.7
(22) Date of filing: 20.10.2020
(51) Int. Cl.: H01S 5/183, H01S 5/022, H01S 5/042, H01S 5/062, H01S 5/42

(54) **SURFACE-EMITTING LASER DEVICE**

(30) Priority: 06.11.2019 JP 2019201616; 31.03.2020 JP 2020064016
(71) Applicant: Sony Semiconductor Solutions Corporation, Atsugi-shi, Kanagawa 243-0014 (JP)
(72) Inventor: MAEDA, Osamu, Kikuchi-gun, Kumamoto 869-1102 (JP); TAKAHASHI, Kazuhiko, Kikuchi-gun, Kumamoto 869-1102 (JP); TAKAHASHI, Yoshihiko, Kikuchi-gun, Kumamoto 869-1102 (JP); TOKUDA, Kota, Atsugi-shi, Kanagawa 243-0014 (JP); MITOMO, Jugo, Kikuchi-gun, Kumamoto 869-1102 (JP); ARAKIDA, Takahiro, Kikuchi-gun, Kumamoto 869-1102 (JP)
(74) Representative: D Young & Co LLP
(86) International application number: PCT/JP2020/039329
(87) International publication number: WO 2021/090670

(57) **Abstract**

A surface light-emission laser device includes: an active layer; a first DBR layer and a second DBR layer that interpose the active layer therebetween; and an insulation film and a metal layer that are provided at a position that faces a light-emission region of the active layer, and correspond to an end part of a reflection mirror on the second DBR layer side as viewed from the active layer. The surface light-emission laser device further includes: a first contact layer provided in the first DBR layer or in contact with the first DBR layer; a second contact layer provided in contact with the second DBR layer; a first electrode layer provided in contact with the first contact layer; and a second electrode layer that is in contact with the second contact layer, and provided at a position that does not face the light-emission region of the active layer.

## Description

### Technical Field

The present disclosure relates to a surface light-emission laser device.

### Background Art

DBR (Diffractive Bragg Reflector) is used in a surface light-emission laser device (see Patent Literature 1, for example).

### Citation List

### Patent Literature

Patent Literature 1: Japanese Unexamined Patent Application Publication No. 2003-258380

### Summary of the Invention

Incidentally, in a field of a surface light-emission laser device, a reduction of a resistance at the time of driving is demanded. Accordingly, it is desirable to provide a surface light-emission laser device that makes it possible to reduce a resistance at the time of driving.

A surface light-emission laser device according to one embodiment of the present disclosure includes: an active layer; a first DBR layer and a second DBR layer that interpose the active layer therebetween; and an insulation film and a metal layer that are provided at a position that faces a light-emission region of the active layer, and correspond to an end part of a reflection mirror on the second DBR layer side as viewed from the active layer. The surface light-emission laser device further includes: a first contact layer provided in the first DBR layer or in contact with the first DBR layer; a second contact layer provided in contact with the second DBR layer; a first electrode layer provided in contact with the first contact layer; and a second electrode layer that is in contact with the second contact layer, and provided at a position that does not face the light-emission region of the active layer.

In the surface light-emission laser device according to one embodiment of the present disclosure, the insulation film and the metal layer are provided at the end part of the reflection mirror on the second DBR layer side as viewed from the active layer. Thus, a laser oscillation is generated at a predetermined oscillation wavelength by the first DBR layer, the second DBR layer, the insulation film, and the metal layer. At this time, it is possible to generate the laser oscillation at the predetermined oscillation wavelength even in a case where the number of pairs of the second DBR layer is less than the number of pairs of the first DBR layer. Hence, a resistance at the time of driving is reduced by an amount by which the number of pairs of the second DBR layer is reduced. Further, in the surface light-emission laser device, the first electrode layer is provided in contact with the first contact layer provided in the first DBR layer or in contact with the first DBR layer, and the second electrode layer separate from the metal layer is provided in contact with the second contact layer. Thus, the resistance at the time of driving is reduced as compared with a case where the first electrode layer is in contact with the first contact layer via an electrically-conductive semiconductor substrate. In addition, it is possible to use an alloy having a low contact resistance as a material of the second electrode layer. Hence, the resistance at the time of driving becomes small as compared with a case where a non-alloy suitable for a material of the reflection mirror is used as the material of the second electrode layer.

### Brief Description of the Drawings

[FIG. 1] FIG. 1 is a diagram illustrating a plan configuration example of a surface light-emission laser device according to an embodiment of the present disclosure.
[FIG. 2] FIG. 2 is a diagram illustrating a cross-sectional configuration example taken along the line A-A in FIG. 1.
[FIG. 3] FIG. 3 is a diagram illustrating a cross-sectional configuration example of an emitter of FIG. 2 and its surrounding.
[FIG. 4] (A) of FIG. 4 is a diagram illustrating a plan configuration example when a bump is omitted on an upper face of the emitter of FIG. 3. (B) of FIG. 4 is a diagram illustrating a plan configuration example when a metal layer is omitted in (A) of FIG. 4.
[FIG. 5] FIG. 5 is a diagram illustrating a configuration example of an insulation film that covers a mesa part of FIG. 3.
[FIG. 6] FIG. 6 is a diagram illustrating a configuration example of the insulation film that covers the mesa part of FIG. 3.
[FIG. 7] FIG. 7 is a diagram illustrating a cross-sectional configuration example of the emitter of FIG. 3 in an enlarged fashion.
[FIG. 8] FIG. 8 is a diagram illustrating a cross-sectional configuration example of the emitter of FIG. 3 in an enlarged fashion.
[FIG. 9] FIG. 9 is a diagram illustrating a cross-sectional configuration example of the emitter of FIG. 3 in an enlarged fashion.
[FIG. 10] FIG. 10 is a diagram illustrating a configuration example of the insulation film that covers the mesa part of FIG. 3.
[FIG. 11] FIG. 11 is a diagram illustrating a cross-sectional configuration example of the emitter of FIG. 3 in an enlarged fashion.
[FIG. 12] FIG. 12 is a diagram illustrating a cross-sectional configuration example of the emitter of FIG. 3 in an enlarged fashion.
[FIG. 13] FIG. 13 is a diagram illustrating a cross-sectional configuration example of the emitter of FIG. 3 in an enlarged fashion.
[FIG. 14] FIG. 14 is a diagram illustrating a plan configuration example when a laser driver IC of FIG. 1 is mounted on a printed circuit board.
[FIG. 15] FIG. 15 is a diagram illustrating a cross-sectional configuration example taken along the line A-A in FIG. 14.
[FIG. 16] FIG. 16 is a cross-sectional diagram illustrating an example of a manufacturing method of a laser chip of FIG. 3.
[FIG. 17] FIG. 17 is a cross-sectional diagram illustrating an example of a manufacturing step following FIG. 16.
[FIG. 18] FIG. 18 is a cross-sectional diagram illustrating an example of a manufacturing step following FIG. 17.
[FIG. 19] FIG. 19 is a cross-sectional diagram illustrating an example of a manufacturing step following FIG. 18.
[FIG. 20] FIG. 20 is a cross-sectional diagram illustrating an example of a manufacturing step following FIG. 19.
[FIG. 21] FIG. 21 is a cross-sectional diagram illustrating an example of a manufacturing step following FIG. 20.
[FIG. 22] FIG. 22 is a cross-sectional diagram illustrating an example of a manufacturing step following FIG. 21.
[FIG. 23] FIG. 23 is a cross-sectional diagram illustrating an example of a manufacturing step following FIG. 22.
[FIG. 24] FIG. 24 is a cross-sectional diagram illustrating an example of a manufacturing step following FIG. 23.
[FIG. 25] FIG. 25 is a diagram illustrating a cross-sectional configuration example of DBR close to the upper face of the emitter of FIG. 3.
[FIG. 26] FIG. 26 is a diagram illustrating a modification example of a cross-sectional configuration of the emitter of FIG. 2 and its surrounding.
[FIG. 27] FIG. 27 is a diagram illustrating an example of an optical field intensity and an energy level of each layer in the mesa part of FIG. 26.
[FIG. 28] FIG. 28 is a diagram illustrating an application example of the surface light-emission laser device according to the above embodiment and the modification examples thereof to a distance measuring apparatus.
[FIG. 29] FIG. 29 is a block diagram depicting an example of schematic configuration of a vehicle control system.
[FIG. 30] FIG. 30 is a diagram of assistance in explaining an example of installation positions of an outside-vehicle information detecting section and an imaging section. Modes for Carrying Out the Invention
Hereinafter, an embodiment of the present disclosure is described in detail with reference to the drawings. The following description is one specific example of the present disclosure, and the present disclosure is not limited to the following embodiment. In addition, the present disclosure is not limited to arrangement, dimensions, dimensional ratios, and the like of the constituent elements illustrated in the respective drawings. It is to be noted that the description is given in the following order.

### 1. Embodiment

An example in which a contact layer is provided between a GaAs substrate and a DBR layer.

### 2. Modification Examples

Examples in which the contact layer is provided in the DBR layer.

### 3. Application Example

An example in which a surface light-emission laser device is applied to a distance measuring apparatus.

### 4. Applied Example

An example in which the distance measuring apparatus is mounted on a mobile body.

### <1. Embodiment

### [Configuration]

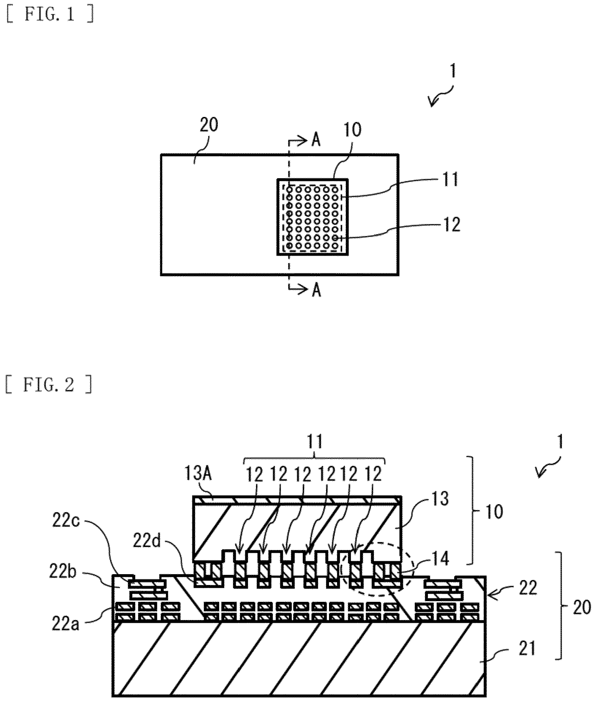

A surface light-emission laser device 1 according to an embodiment of the present disclosure will be described. FIG. 1 illustrates an upper face configuration example of the surface light-emission laser device 1. FIG. 2 illustrates a cross-sectional configuration example of the surface light-emission laser device 1 of FIG. 1 taken along the line A-A in FIG. 1.

The surface light-emission laser device 1 is a laser of a backside illumination type which is suitably applicable to an application that demands a thin size and low power consumption, an application that demands a thin size and large area, etc. The surface light-emission laser device 1 includes a laser chip 10 and a laser driver IC 20. In the present embodiment, the laser chip 10 is disposed on the laser driver IC 20. The laser chip 10 is electrically coupled to the laser driver IC 20 via a plurality of bumps 14, for example.

The laser chip 10 has, for example, a substrate 13, an emitter array 11 formed on a face on the laser driver IC 20 side of the substrate 13, the plurality of bumps 14 formed on a face on the laser driver IC 20 side of the substrate 13, and an AR (Antireflection) layer 13A formed on a face (a light output face) of the substrate 13 on the opposite side of the laser driver IC 20. The emitter array 11 is disposed on the opposite side of the light output face side of the substrate 13. The AR layer 13A is configured by, for example, a stacked body in which SiO₂ and SiN are stacked.

For example, as illustrated in FIGs. 1 and 2, the emitter array 11 is configured by a plurality of emitters 12 disposed on the same substrate 13. The plurality of emitters 12 is, for example, disposed on the substrate 13 at equal intervals in a row direction, and are disposed at equal intervals in a column direction as well. It should be noted that the plurality of emitters 12 may be randomly disposed on the same substrate 13. Each of the emitters 12 is configured by a semiconductor laser of a surface light-emission type that emits laser light in a stacking direction. In the present embodiment, each of the emitters 12 emits the laser light on the opposite side of the laser driver IC 20 via the substrate 13 and the AR layer 13A. The substrate 13 is configured by, for example, a semi-insulating semiconductor substrate (e.g., a Si-GaAs substrate) that allows light emitted from the emitter 12 to transmit therethrough.

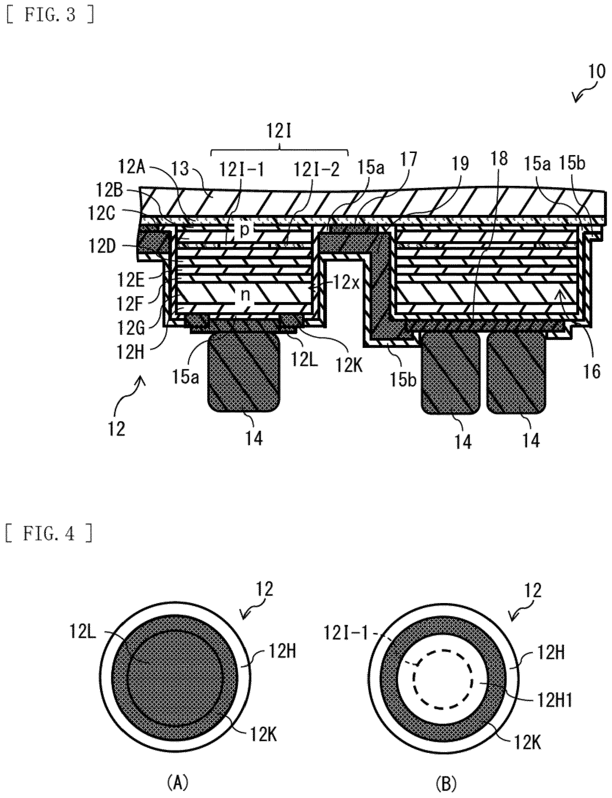

Referring to FIG. 3, the emitters 12 each have, for example, a columnar perpendicular resonator structure (a mesa part 12x) formed by stacking, in order from the substrate 13 side, an etching stop layer 12B, a DBR layer 12C, a spacer layer 12D, an active layer 12E, a spacer layer 12F, a DBR layer 12G, and a contact layer 12H. A diameter (a mesa diameter) of each mesa part 12x is slightly smaller than a beam pitch of laser light to be outputted from each mesa part 12x. For example, in a case where the beam pitch is about 18 µm, the diameter (the mesa diameter) of each mesa part 12x is about 14 µm. In each mesa part 12x, the DBR layers 12C and 12G interpose the active layer 12E therebetween. Each emitter 12 has a contact layer 12A that is in contact with the etching stop layer 12B. The contact layer 12A is a layer for causing each mesa part 12x (specifically, the DBR layer 12C to be described later) and a later-described electrode layer 17 to be in ohmic contact with each other. The contact layer 12A is provided between each mesa part 12x and the substrate 13 and is in contact with each mesa part 12x and the substrate 13. The substrate 13 is provided on a side, of the contact layer 12A, that is opposite to the active layer 12E. The contact layer 12A corresponds to one specific example of a "first contact layer" of the present disclosure. The contact layer 12H corresponds to one specific example of a "second contact layer" of the present disclosure.

The contact layer 12A is shared in each of the emitters 12. That is, the plurality of mesa parts 12x is disposed on the same contact layer 12A, and each mesa part 12x protrudes on the laser driver IC 20 side in the laser chip 10. In each mesa part 12x, the contact layer 12H is an end face on the laser driver IC 20 side. Hereinafter, the end face, of the mesa part 12x, on the laser driver IC 20 side may sometimes be referred to as an upper face of the mesa part 12x for convenience. In each emitter 12, a current confining layer 121 is provided in each DBR layer 12G. It should be noted that FIG. 3 illustrates a cross-sectional configuration example of a portion surrounded by a broken line in the laser chip 10 illustrated in FIG. 2. In the present embodiment, each mesa part 12x is formed of, for example, the substrate 13 as a crystal-grown substrate.

The contact layer 12A of each mesa part 12x is configured by, for example, a GaAs-based semiconductor. The contact layer 12A includes, for example, p-type Alₓ₁Ga₁₋ₓ₁As (0≤x1<1). The etching stop layer 12B includes, for example, p-type Inₓ₂Ga₁₋ₓ₂P (0<x2<1). The DBR layer 12C has a configuration in which a low refractive index layer (not illustrated) and a high refractive index layer (not illustrated) are alternately stacked. In the DBR layer 12C, the low refractive index layer includes p-type Alₓ₃Ga₁₋ₓ₃As (0<x3<1) having an optical thickness of λ×1/4 (λ1 is an oscillation wavelength), for example, and the high refractive index layer includes p-type Alₓ₄Ga₁₋ₓ₄As (0≤x4<x3) having an optical thickness of λ×1/4, for example. The spacer layer 12D includes, for example, p-type Alₓ₅Ga₁₋ₓ₅As (0≤x5<1). The contact layer 12A, the etching stop layer 12B, the DBR layer 12C, and the spacer layer 12D include, for example, a p-type impurity such as carbon (C). That is, the contact layer 12A, the etching stop layer 12B, the DBR layer 12C, and the spacer layer 12D are configured by p-type semiconductors.

The active layer 12E has, for example, a multi-quantum-well structure in which a well layer (not illustrated) that includes undoped Inₓ₆Ga₁₋ₓ₆As (0<x6<1) and a barrier layer (not illustrated) that includes undoped Inₓ₇Ga₁₋ₓ₇As (0<x7<x6) are alternately stacked. It should be noted that a region, of the active layer 12E, that faces a current injection region 121-1 (to be described later) serves as a light-emission region.

The spacer layer 12F includes, for example, n-type Alₓ₈Ga₁₋ₓ₈As (0≤x8<1). The DBR layer 12G has a configuration in which a low refractive index layer (not illustrated) and a high refractive index layer (not illustrated) are alternately stacked. In the DBR layer 12G, the low refractive index layer includes, for example, n-type Alₓ₉Ga₁₋ₓ₉As (0<x9<1) having an optical thickness of λ×1/4, and the high refractive index layer includes, for example, n-type Alₓ₁₀Ga₁₋ₓ₁₀As (0≤x10<x9) having an optical thickness of λ×1/4. The contact layer 12H is a layer for causing the DBR layer 12G and a ring electrode layer 12K to be in ohmic contact with each other. The contact layer 12H includes, for example, n-type Alₓ₁₁Ga₁₋ₓ₁₁As (0≤x11<1). The spacer layer 12F, the DBR layer 12G, and the contact layer 12H include an n-type impurity such as silicon (Si). That is, the spacer layer 12F, the DBR layer 12G, and the contact layer 12H are configured by n-type semiconductors.

The number of pairs of the low refractive index layer and the high refractive index layer in the DBR layer 12G is, for example, less than the number of pairs of the low refractive index layer and the high refractive index layer in the DBR layer 12C. The number of pairs of the DBR layer 12G is equal to or less than half of the number of pairs necessary for the DBR layer when an insulation film 15a and a metal layer 12L described later are not provided. This is because the insulation film 15a and the metal layer 12L assist a light reflection function of the DBR layer 12G, and it is possible to reduce the number of pairs of the low refractive index layer and the high refractive index layer in the DBR layer 12G by the light reflection capability of the insulation film 15a and the metal layer 12L.

The current confining layer 121 has the current injection region 121-1 and a current confining region 121-2. The current confining region 121-2 is formed in a surrounding region of the current injection region 121-1. The current injection region 121-1 includes, for example, p-type Alₓ₁₂Ga₁₋ₓ₁₂As (0<x12≤1). The current confining region 121-2 includes, for example, Al₂O₃ (aluminum oxide), and is obtained, for example, by oxidizing high concentration of Al included in an oxidized layer 12M (described later) from a side face. Accordingly, the current confining layer 121 has the function of constricting a current.

Referring to FIG. 3 and (B) of FIG. 4, the emitters 12 each further have, for example, the ring electrode layer 12K in contact with the contact layer 12H. That is, the ring electrode layer 12K is disposed on a side opposite to the light output face of the substrate 13, and is formed in contact with the upper face of the mesa part 12x. The ring electrode layer 12K corresponds to one specific example of a "second electrode layer" of the present disclosure. The ring electrode layer 12K is a ring-shaped electrode formed at a position that does not face the light-emission region (or the current injection region 12I-1) of the active layer 12E, and has an opening at a position that faces the light-emission region (or the current injection region 121-1) of the active layer 12E. The ring electrode layer 12K is in contact with a portion, of the contact layer 12H, that does not face the light-emission region (or the current injection region 121-1) of the active layer 12E. Accordingly, the ring electrode layer 12K is electrically coupled to the DBR layer 12G via the contact layer 12H. The ring electrode layer 12K includes an alloy. The ring electrode layer 12K includes, for example, an alloy in contact with the contact layer 12H, and has a stacked body in which, for example, AuGe, Ni, and Au are stacked in order from the contact layer 12H side.

Referring to FIG. 3 and (A) of FIG. 4, the emitters 12 each further have, for example, the metal layer 12L in contact with the ring electrode layer 12K. The metal layer 12L corresponds to one specific example of a "metal layer" of the present disclosure. The metal layer 12L is so formed as to cover an opening of the ring electrode layer 12K, and an outer edge part of the metal layer 12L (a part that does not face the current injection region 121-1) is in contact with the ring electrode layer 12K. Accordingly, the metal layer 12L is electrically coupled to the DBR layer 12G via the ring electrode layer 12K and the contact layer 12H. The metal layer 12L is also in contact with a bump 14 and is electrically coupled to the laser driver IC 20 via the bump 14. The metal layer 12L is electrically coupled to, for example, NMOS in the laser driver IC 20. The metal layer 12L includes a non-alloy, and has a stacked body in which, for example, Ti, Pt, and Au are stacked in order from the ring electrode layer 12K side. The bump 14 includes Au, for example.

The metal layer 12L is not in direct contact with the upper face (the contact layer 12H) of the mesa part 12x. A middle part (a part that faces the current injection region 121-1) of the metal layer 12L is stacked on the upper face (the contact layer 12H) of the mesa part 12x via an insulation film 15a to be described later. The middle part of the metal layer 12L and the insulation film 15a are provided at a position that faces the light-emission region (or the current injection region 121-1) of the active layer 12E, and correspond to an end part of a reflection mirror on the DBR layer 12G side as viewed from the active layer 12E. The part, of the insulation film 15a, that is in contact with the upper face (the contact layer 12H) of the mesa part 12x corresponds to one specific example of an "insulation film" of the present disclosure.

Referring to FIG. 3, the emitters 12 each further have, for example, the electrode layer 17 in contact with the contact layer 12A. The electrode layer 17 corresponds to one specific example of a "first electrode layer" of the present disclosure. The electrode layer 17 is disposed on a side opposite to the light output face of the substrate 13, and is in contact with a position, of the contact layer 12A, that does not face the mesa part 12x. The electrode layer 17 is in contact with, for example, a location, of the contact layer 12A, that corresponds to a foot of the mesa part 12x. Accordingly, the electrode layer 17 is electrically coupled to the DBR layer 12C via the contact layer 12A. The electrode layer 17 includes a non-alloy, and has a stacked body in which, for example, Ti, Pt, and Au are stacked in order from the contact layer 12A side.

Referring to FIG. 3, the emitters 12 each further have, for example, the insulation films 15a and 15b that protect the mesa part 12x. The insulation film 15a covers a side face of the mesa part 12x, and has an opening at a part, of the mesa part 12x, that faces the ring electrode layer 12K ((B) of FIG. 4). The insulation film 15a further covers a part, of the mesa part 12x, exposed inside the opening of the ring electrode layer 12K (an exposed part 12H1 in (B) of FIG. 4), and also covers a part constituting a base of a later-described electrode layer 18 (a base section 16).

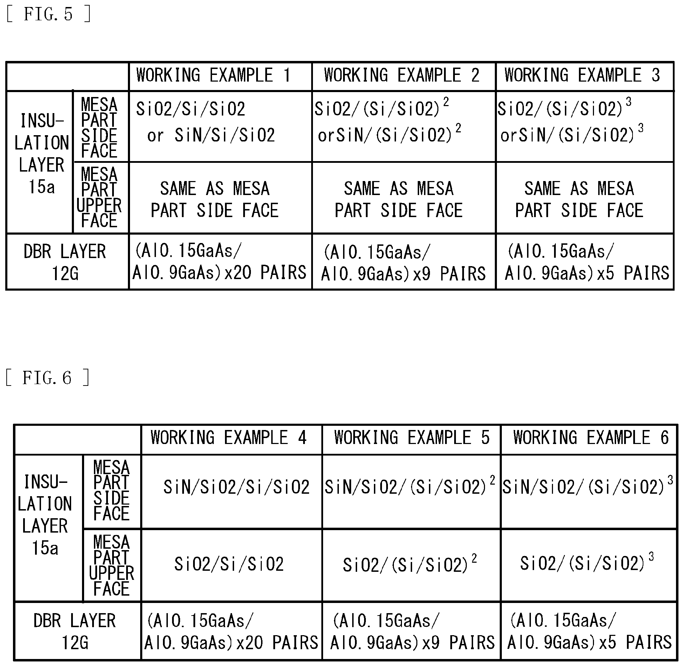

For example, as illustrated in Working Example 1 of FIG. 5, the insulation film 15a is configured by a stacked body in which SiO₂, Si, and SiO₂ are stacked in order from a side face side of the mesa part 12x. It should be noted that, as illustrated in Working Example 1 of FIG. 5, for example, the insulation film 15a may be configured by a stacked body in which SiN, Si, and SiO₂ are stacked in order from the side face side of the mesa part 12x. SiN serves to suppress an entry of moisture from the outside. At this time, SiN (a SiN layer) included in the insulation film 15a is in contact with the side face of the mesa part 12x. Further, for example, as illustrated in Working Example 1 of FIG. 5, the insulation film 15a is configured by a stacked body in which SiO₂, Si, and SiO₂ are stacked in order from an upper face side of the mesa part 12x. It should be noted that, as illustrated in Working Example 1 of FIG. 5, for example, the insulation film 15a may be configured by a stacked body in which SiN, Si, and SiO₂ are stacked in order from the upper face side of the mesa part 12x. The insulation film 15a has the same layer configuration as each other, for example, at the side face and the upper face of the mesa part 12x.

For example, as illustrated in Working Example 2 of FIG. 5, the insulation film 15a may be configured by a stacked body in which SiO₂, Si, SiO₂, Si, and SiO₂ are stacked in order from the side face side of the mesa part 12x. For example, as illustrated in Working Example 2 of FIG. 5, the insulation film 15a may be configured by a stacked body in which SiN, Si, SiO₂, Si, and SiO₂ are stacked in order from side face side of the mesa part 12x. At this time, SiN (a SiN layer) included in the insulation film 15a is in contact with the side face of the mesa part 12x. Further, for example, as illustrated in Working Example 2 of FIG. 5, the insulation film 15a may be configured by a stacked body in which SiO₂, Si, SiO₂, Si, and SiO₂ are stacked in order from the upper face side of the mesa part 12x. For example, as illustrated in Working Example 2 of FIG. 5, the insulation film 15a may be configured by a stacked body in which SiN, Si, SiO₂, Si, and SiO₂ are stacked in order from the upper face side of the mesa part 12x. The insulation film 15a has the same layer configuration as each other, for example, at the side face and the upper face of the mesa part 12x. In this manner, by stacking two pairs of Si and SiO₂ at the upper face of the mesa part 12x, it is possible for the insulation film 15a to take a role as the reflection mirror, thereby making it possible to reduce the number of pairs of the high refractive index layer and the low refractive index layer included in the DBR 12G to about one half (e.g., 9 pairs) as compared with Working Example 1.

For example, as illustrated in Working Example 3 of FIG. 5, the insulation film 15a may be configured by a stacked body in which SiO₂, Si, SiO₂, Si, SiO₂, Si, and SiO₂ are stacked in order from the side face side of the mesa part 12x. For example, as illustrated in Working Example 3 of FIG. 5, the insulation film 15a may be configured by a stacked body in which SiN, Si, SiO₂, Si, SiO₂, Si, and SiO₂ are stacked in order from side face side of the mesa part 12x. At this time, SiN (the SiN layer) included in the insulation film 15a is in contact with the side face of the mesa part 12x. Further, for example, as illustrated in Working Example 3 of FIG. 5, the insulation film 15a may be configured by a stacked body in which SiO₂, Si, SiO₂, Si, SiO₂, Si, and SiO₂ are stacked in order from the upper face side of the mesa part 12x. For example, as illustrated in Working Example 3 of FIG. 5, the insulation film 15a may be configured by a stacked body in which SiN, Si, SiO₂, Si, SiO₂, Si, and SiO₂ are stacked in order from the upper face side of the mesa part 12x. The insulation film 15a has the same layer configuration as each other, for example, at the side face and the upper face of the mesa part 12x. In this manner, by stacking three pairs of Si and SiO₂ at the upper face of the mesa part 12x, it is possible for the insulation film 15a to take a role as the reflection mirror, thereby making it possible to reduce the number of pairs of the high refractive index layer and the low refractive index layer included in the DBR 12Gto about one quarter (e.g., 5 pairs) as compared with Working Example 1.

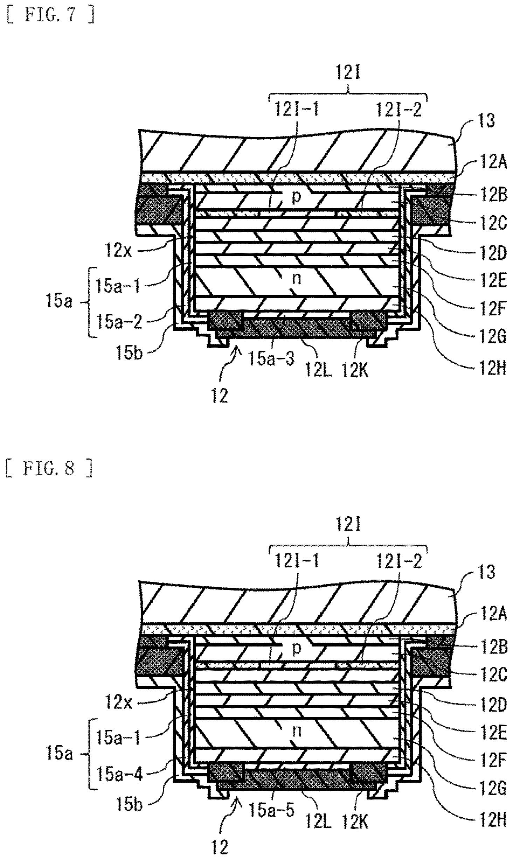

For example, as illustrated in Working Example 4 of FIG. 6, the insulation film 15a may be configured by a stacked body in which SiN, SiO₂, Si, and SiO₂ are stacked in order from the side face side of the mesa part 12x. At this time, SiN (the SiN layer) included in the insulation film 15a is in contact with the side face of the mesa part 12x. For example, as illustrated in Working Example 4 of FIG. 6, the insulation film 15a may be configured by a stacked body in which SiO₂, Si, and SiO₂ are stacked in order from the upper face side of the mesa part 12x. In Working Example 4 of FIG. 6, for example, as illustrated in FIG. 7, the insulation film 15a is configured, on the side face side of the mesa part 12x, by a SiN layer 15a-1 in contact with the side face of the mesa part 12x and a stacked body (a stacked body in which SiO₂, Si, and SiO₂ are stacked in order) 15a-2 in contact with the SiN layer 15a-1. Further, in Working Example 4 of FIG. 6, for example, as illustrated in FIG. 7, the insulation film 15a is configured, on the upper face side of the mesa part 12x, by a stacked body (a stacked body in which SiO₂, Si, and SiO₂ are stacked in order) 15a-3 in contact with the upper face side of the mesa part 12x. The stacked bodies 15a-2 and 15a-3 are formed collectively in the same process, for example.

For example, as illustrated in Working Example 5 of FIG. 6, the insulation film 15a may be configured by a stacked body in which SiN, SiO₂, Si, SiO₂, Si, and SiO₂ are stacked in order from the side face side of the mesa part 12x. At this time, SiN (the SiN layer) included in the insulation film 15a is in contact with the side face of the mesa part 12x. Further, for example, as illustrated in Working Example 5 of FIG. 6, the insulation film 15a may be configured by a stacked body in which SiO₂, Si, SiO₂, Si, and SiO₂ are stacked in order from the upper face side of the mesa part 12x. In Working Example 5 of FIG. 5, for example, as illustrated in FIG. 8, the insulation film 15a is configured, on the side face side of the mesa part 12x, by the SiN layer 15a-1 in contact with the side face of the mesa part 12x and a stacked body 15a-4 (a stacked body in which SiO₂, Si, SiO₂, Si, and SiO₂ are stacked in order) in contact with the SiN layer 15a-1. Further, in Working Example 5 of FIG. 5, for example, as illustrated in FIG. 8, the insulation film 15a is configured, on the upper face side of the mesa part 12x, by a stacked body (a stacked body in which SiO₂, Si, SiO₂, Si, and SiO₂ are stacked in order) 15a-5 in contact with the upper face side of the mesa part 12x. The stacked bodies 15a-4 and 15a-5 are formed collectively in the same process, for example. In this manner, by stacking two pairs of Si and SiO₂ at the upper face of the mesa part 12x, it is possible for the insulation film 15a to take a role as the reflection mirror, thereby making it possible to reduce the number of pairs of the high refractive index layer and the low refractive index layer included in the DBR 12G to about one half (e.g., 9 pairs) as compared with Working Example 1.

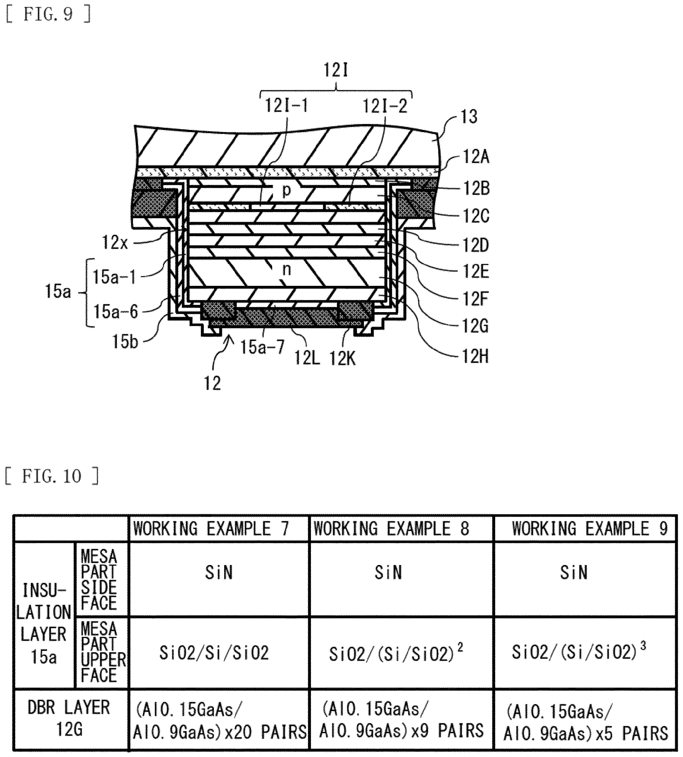

For example, as illustrated in Working Example 6 of FIG. 6, the insulation film 15a may be configured by a stacked body in which SiN, SiO₂, Si, SiO₂, Si, SiO₂, Si, and SiO₂ are stacked in order from the side face side of the mesa part 12x. At this time, SiN (the SiN layer) included in the insulation film 15a is in contact with the side face of the mesa part 12x. Further, for example, as illustrated in Working Example 6 of FIG. 6, the insulation film 15a may be configured by a stacked body in which SiO₂, Si, SiO₂, Si, SiO₂, Si, and SiO₂ are stacked in order from the upper face side of the mesa part 12x. In Working Example 6 of FIG. 5, for example, as illustrated in FIG. 9, the insulation film 15a is configured, on the side face side of the mesa part 12x, by the SiN layer 15a-1 in contact with the side face of the mesa part 12x and a stacked body 15a-6 (a stacked body in which SiO₂, Si, SiO₂, Si, SiO₂, Si, and SiO₂ are stacked in order) in contact with the SiN layer 15a-1. Further, in Working Example 6 of FIG. 5, for example, as illustrated in FIG. 9, the insulation film 15a is configured, on the upper face side of the mesa part 12x, by a stacked body (a stacked body in which SiO₂, Si, SiO₂, Si, SiO₂, Si, and SiO₂ are stacked in order) 15a-7 in contact with the upper face side of the mesa part 12x. The stacked bodies 15a-6 and 15a-7 are formed collectively in the same process, for example. In this manner, by stacking three pairs of Si and SiO₂ at the upper face of the mesa part 12x, it is possible for the insulation film 15a to take a role as the reflection mirror, thereby making it possible to reduce the number of pairs of the high refractive index layer and the low refractive index layer included in the DBR 12Gto about one quarter (e.g., 5 pairs) as compared with Working Example 1.

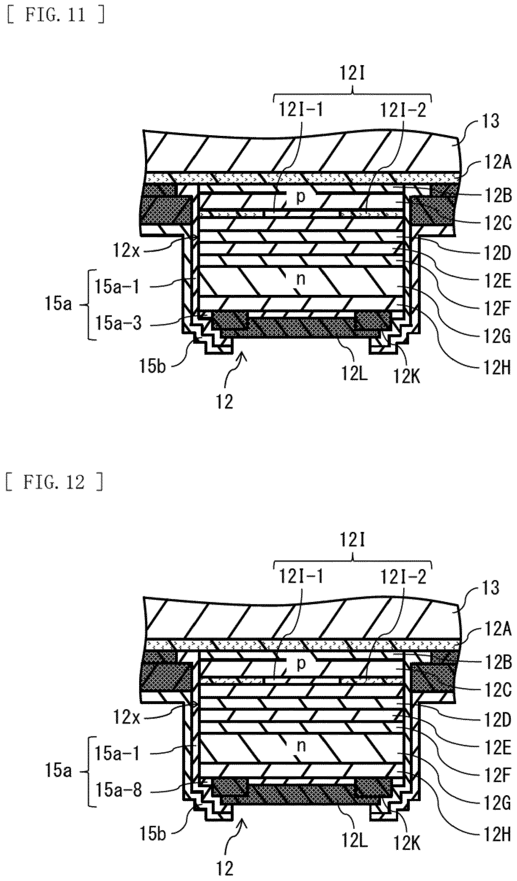

For example, as illustrated in Working Example 7 of FIG. 10, the insulation film 15a may be configured by, for example, a SiN layer in contact with the side face of the mesa part 12x. At this time, SiN (the SiN layer) included in the insulation film 15a is in contact with the side face of the mesa part 12x. Further, for example, as illustrated in Working Example 7 of FIG. 10, the insulation film 15a may be configured by a stacked body in which SiO₂, Si, and SiO₂ are stacked in order from the upper face side of the mesa part 12x. In Working Example 7 of FIG. 10, for example, the insulation film 15a is configured, on the side face side of the mesa part 12x, by the SiN layer 15a-1 in contact with the side face of the mesa part 12x as illustrated in FIG. 11. Further, in Working Example 7 of FIG. 10, for example, the insulation film 15a is configured, on the upper face side of the mesa part 12x, by the stacked body (the stacked body in which SiO₂, Si, and SiO₂ are stacked in order) 15a-3 in contact with the upper face side of the mesa part 12x as illustrated in FIG. 11.

For example, as illustrated in Working Example 8 of FIG. 10, the insulation film 15a may be configured by, for example, the SiN layer in contact with the side face of the mesa part 12x. At this time, SiN (the SiN layer) included in the insulation film 15a is in contact with the side face of the mesa part 12x. Further, for example, as illustrated in Working Example 8 of FIG. 10, the insulation film 15a may be configured by a stacked body in which SiO₂, Si, SiO₂, Si, and SiO₂ are stacked in order from the upper face side of the mesa part 12x. In Working Example 8 of FIG. 10, for example, the insulation film 15a is configured, on the side face side of the mesa part 12x, by the SiN layer 15a-1 in contact with the side face of the mesa part 12x as illustrated in FIG. 12. Further, in Working Example 8 of FIG. 10, for example, the insulation film 15a is configured, on the upper face side of the mesa part 12x, by a stacked body (a stacked body in which SiO₂, Si, SiO₂, Si, and SiO₂ are stacked in order) 15a-8 in contact with the upper face side of the mesa part 12x as illustrated in FIG. 12.

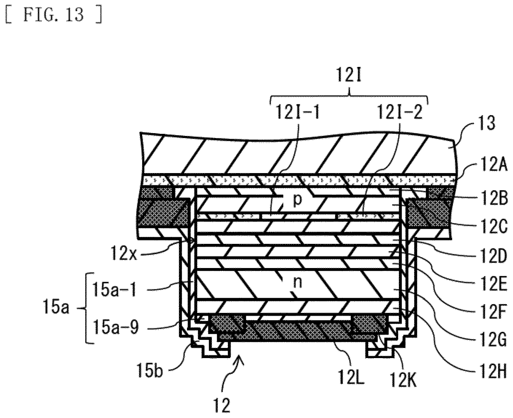

For example, as illustrated in Working Example 9 of FIG. 10, the insulation film 15a may be configured by, for example, the SiN layer in contact with the side face of the mesa part 12x. At this time, SiN (the SiN layer) included in the insulation film 15a is in contact with the side face of the mesa part 12x. Further, for example, as illustrated in Working Example 9 of FIG. 10, the insulation film 15a may be configured by a stacked body in which SiO₂, Si, SiO₂, Si, SiO₂, Si, and SiO₂ are stacked in order from the upper face side of the mesa part 12x. In Working Example 9 of FIG. 10, for example, the insulation film 15a is configured, on the side face side of the mesa part 12x, by the SiN layer 15a-1 in contact with the side face of the mesa part 12x as illustrated in FIG. 13. Further, in Working Example 9 of FIG. 10, for example, the insulation film 15a is configured, on the upper face side of the mesa part 12x, by a stacked body (a stacked body in which SiO₂, Si, SiO₂, Si, SiO₂, Si, and SiO₂ are stacked in order) 15a-9 in contact with the upper face side of the mesa part 12x as illustrated in FIG. 13.

The insulation film 15b is in contact with a surface of the insulation film 15a at least in a portion of the side face of the mesa part 12x, and has an opening at a part, of the mesa part 12x, that faces the ring electrode layer 12K and the metal layer 12L. The insulation film 15b further covers a coupling layer 19 to be described later. The insulation film 15b is configured by, for example, a SiN film.

The laser chip 10 has the base section 16 and the electrode layer 18 on the opposite side of the light output face of the substrate 13 and at a surrounding part of the emitter array 11 as illustrated in FIGs. 2 and 3, for example. The electrode layer 18 is formed on a face on the laser driver IC 20 side of the base section 16 that has a structure common to the perpendicular resonator structure of the mesa part 12x. The electrode layer 18 corresponds to one specific example of a "third electrode layer" of the present disclosure.

The laser chip 10 has the coupling layer 19 that electrically couples the electrode layer 17 and the electrode layer 18 to each other as illustrated in FIG. 3, for example. The coupling layer 19 corresponds to one specific example of a "coupling layer" of the present disclosure. The coupling layer 19 extends from an upper face of the base section 16 through a side face of the base section 16 to a foot of each emitter 12, and is coupled to the electrode layer 17 and the electrode layer 18. Accordingly, the electrode layer 18 is electrically coupled to the DBR layer 12C of each emitter via the coupling layer 19, the electrode layer 17, and the contact layer 12A. The electrode layer 18 is also in contact with the bump 14, and is electrically coupled to the laser driver IC 20 via the bump 14. The electrode layer 18 has, for example, a potential same as a reference potential of the laser driver IC 20. The electrode layer 18 has a stacked body in which Ti, Pt, and Au are stacked in this order from the upper face side of the base section 16, for example. The coupling layer 19 is, for example, an Au plating layer.

The laser driver IC 20 is provided to face a face on the plurality of emitters 12 side of the laser chip 10. The laser driver IC 20 is electrically coupled to the ring electrode layer 12K of each emitter 12 and the electrode layer 18 via the plurality of bumps 14, and controls light emission and light extinction of each emitter 12 via the plurality of bumps 14, the ring electrode layer 12K, and the electrode layer 18. The laser driver IC 20 independently drives the plurality of emitters 12 provided in the laser chip 10 to cause all or a part of the plurality of emitters 12 to emit light. The laser driver IC 20 drives, for example, all or a part of the emitters 12 selected by a later-described system controller 30 among the plurality of emitters 12. The laser driver IC 20 has, for example, a Si substrate 21 and a wiring line layer 22 formed on the Si substrate 21.

The laser driver IC 20 has, on the Si substrate 21, an NMOS driver that controls a voltage to be applied to the laser chip 10. The NMOS driver generates a drive pulse that performs the light emission and the light extinction of the plurality of emitters 12 provided on the laser chip 10. The NMOS driver is electrically coupled to the laser chip 10 via the wiring line layer 22.

The wiring line layer 22 includes, in an insulation layer 22b, a plurality of metal layers 22a, a plurality of connection pads 22c, and a plurality of connection pads 22d, for example. The plurality of metal layers 22a electrically couples the NMOS driver in the Si substrate 21 and the plurality of connection pads 22d to each other. The plurality of connection pads 22d is disposed at a position, of the wiring line layer 22, that faces the laser chip 10, and is electrically coupled to the plurality of bumps 14 provided on the laser chip 10. The plurality of connection pads 22c is disposed at a position, of the wiring line layer 22, that does not face the laser chip 10, and is electrically coupled to, for example, a bonding wire 54 described later. It should be noted that how the laser chip 10 and the laser driver IC 20 are electrically coupled is not limited to what is illustrated in FIG. 2.

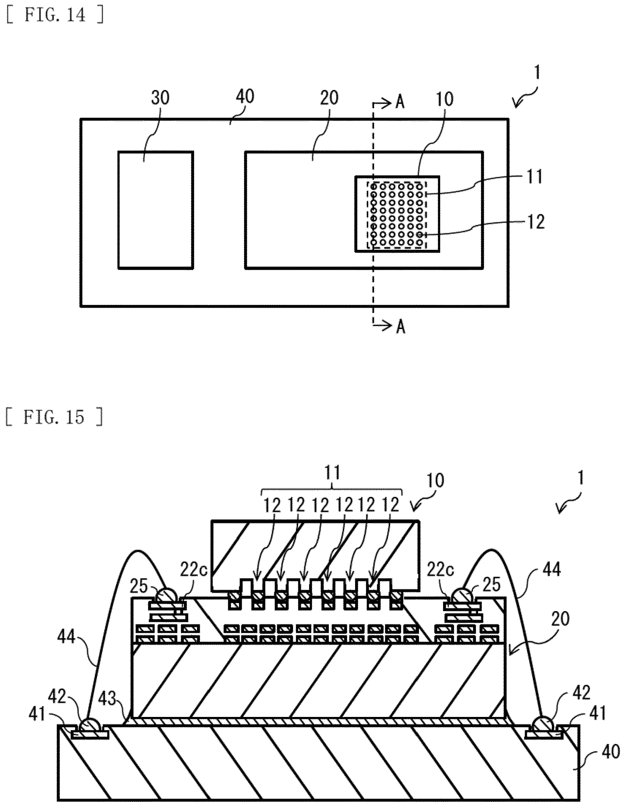

FIG. 14 illustrates a plan configuration example when the laser driver IC 20 is mounted on the printed circuit board 40. In the surface light-emission laser device 1, the printed circuit board 40 is provided with, for example, the system controller 30 besides the laser driver IC 20. FIG. 15 illustrates a cross-sectional configuration example taken along the line A-A in FIG. 14. A joining layer 43 is provided between the laser driver IC 20 and the printed circuit board 40. The joining layer 43 fixes the laser driver IC 20 and the printed circuit board 40 to each other. The joining layer 43 includes, for example, a resin material having an insulating property.

The laser driver IC 20 and the printed circuit board 40 are electrically coupled to each other by a bonding wire 44. One end of the bonding wire 44 is fixed to the connection pad 22c of the laser driver IC 20 by a solder 25, and the other end of the bonding wire 44 is fixed to the connection pad 41 of the printed circuit board 40 by a solder 42.

### [Manufacturing Method]

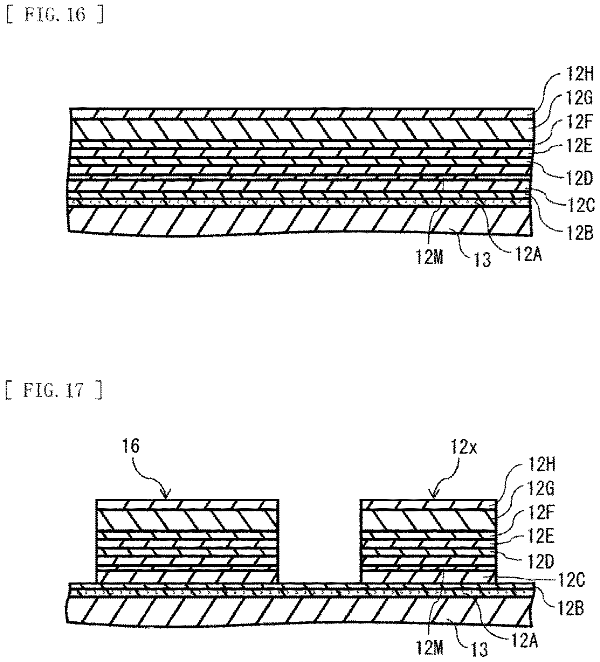

Next, a manufacturing method of the surface light-emission laser device 1 according to the present embodiment will be described. FIGs. 16 to 24 each illustrate an example of a manufacturing step of the laser chip 10 in the surface light-emission laser device 1.

In order to manufacture the laser chip 10, compound semiconductors are collectively formed on the substrate 13 that includes GaAs, for example, by an epitaxial crystal growth method such as MOCVD (Metal Organic Chemical Vapor Deposition: Metal Organic Vapor Deposition) method. At this time, as raw materials of the compound semiconductors, for example, a methyl-based organometallic gas such as trimethylaluminum (TMAl), trimethylgallium (TMGa), or trimethylindium (TMIn) and an arsine (AsH₃) gas are used, and disilane (Si₂H₆), for example, is used as a raw material of a donor impurity. For example, carbon tetrabromide (CBr₄) is used as a raw material of an acceptor impurity.

First, the contact layer 12A, the etching stop layer 12B, the DBR layer 12C including the oxidized layer 12M, the spacer layer 12D, the active layer 12E, the spacer layer 12F, the DBR layer 12G, and the contact layer 12H are formed in this order on a surface of the substrate 13 by an epitaxial crystal growth method such as a MOCVD method (FIG. 16). Next, for example, a resist layer (not illustrated) having a predetermined pattern is formed, following which the contact layer 12H, the DBR layer 12G, the spacer layer 12F, the active layer 12E, the spacer layer 12D, and the DBR layer 12C are selectively etched using the resist layer as a mask. At this time, it is preferable to use, for example, RIE (Reactive Ion Etching) by a Cl-based gas. Thus, for example, the columnar mesa part 12x and the columnar base section 16 having a height that reaches a surface of the etching stop layer 12B are formed as illustrated in FIG. 17. At this time, the oxidized layer 12M is exposed on the side face of the mesa part 12x. Thereafter, the resist layer is removed.

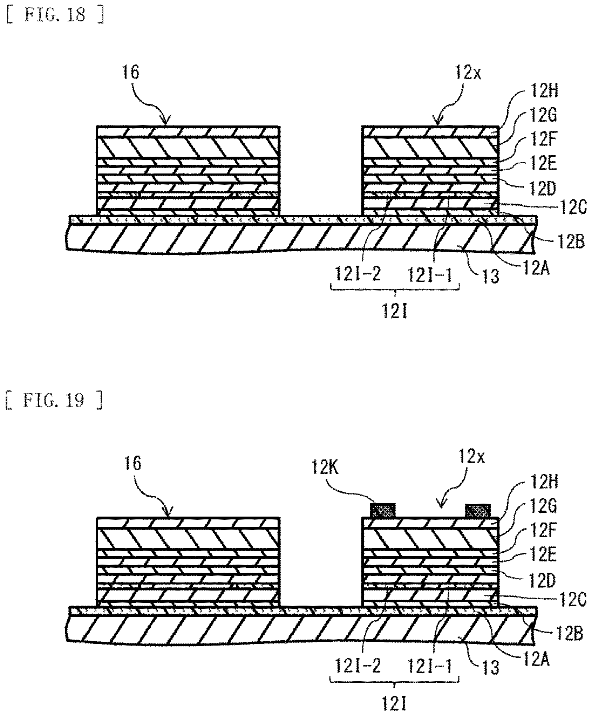

Next, an oxidation treatment is performed in a water vapor atmosphere at a high temperature to selectively oxidize Al included in the oxidized layer 12M from the side face of the mesa part 12x. Alternatively, Al included in the oxidized layer 12M is selectively oxidized from the side face of the mesa part 12x by a wet oxidation method. Thus, an outer edge region of the oxidized layer 12M becomes an insulation layer (aluminum oxide) in the mesa part 12x, and the current confining layer 121 is formed (FIG. 18).

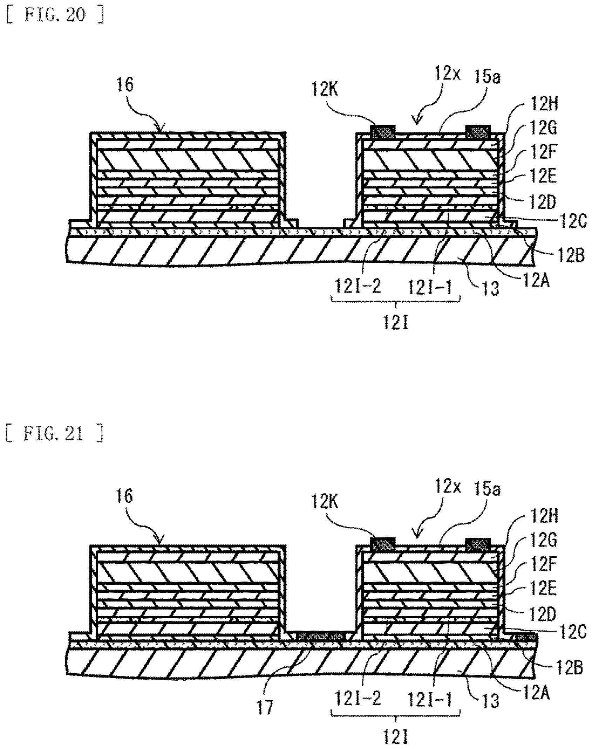

Next, the ring electrode layer 12K is formed on the upper face of the mesa part 12x (FIG. 19). Subsequently, the insulation film 15a having the openings at a part that faces the ring electrode layer 12K and the foot part of the mesa part 12x is formed using, for example, CVD or the like, following which the electrode layer 17 is formed in the opening, of the insulation film 15a, provided at the foot part of the mesa part 12x using, for example, vapor deposition or sputtering (FIGs. 20 and 21).

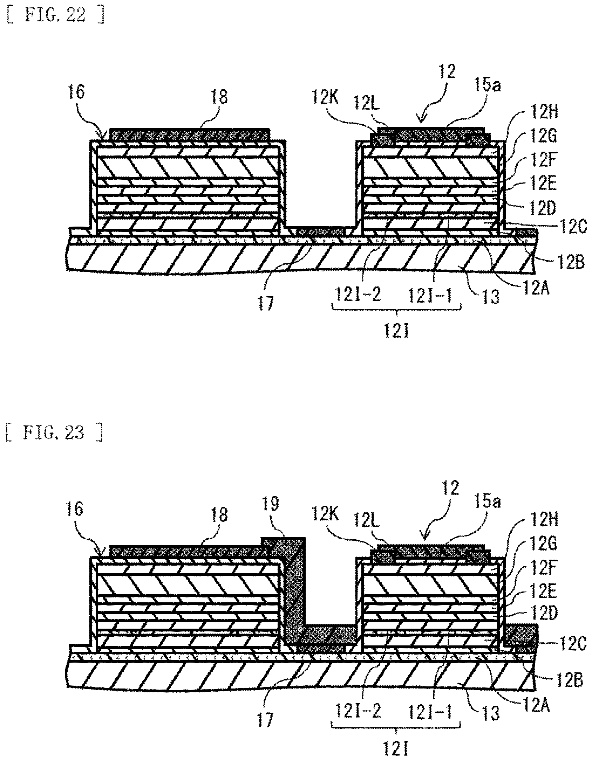

Next, for example, by using a vapor deposition or sputtering or the like, the metal layer 12L is so formed on the upper face of the mesa part 12x as to block the opening of the ring electrode layer 12K, and the electrode layer 18 is formed on the base section 16 (FIG. 22). In this manner, the plurality of emitters 12 is formed on the contact layer 12A. Next, the coupling layer 19 that couples the electrode layer 17 of each emitter 12 and the electrode layer 18 on the base section 16 is formed using, for example, a plating method (FIG. 23). It should be noted that, prior to using the plating method, a underlayer as a seed of plating is formed in advance using, for example, a vapor deposition or sputtering at a location, of the insulation film 15a, at which the coupling layer 19 is to be formed. The coupling layer 19 has a thickness that makes it possible to sufficiently prevent a voltage drop (e.g., about 2 µm).

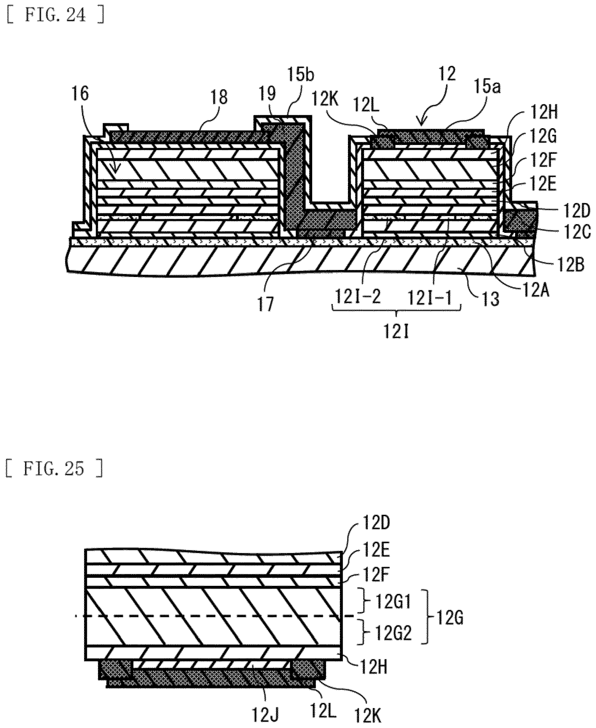

Next, a part, of the insulation film 15a, on which dicing is to be performed is removed, following which the insulation film 15b that covers the side face of each emitter 12 and a surface of the coupling layer 19 is formed using, for example, CVD (FIG. 24). Subsequently, the substrate 13 is thinned using, for example, a grinder or the like, following which the AR layer 13A is formed on a back surface of the substrate 13 by, for example, CVD or sputtering. Lastly, the dicing is performed on the substrate 13. In this way, the laser chip 10 is manufactured.

### [Effects]

Next, effects of the surface light-emission laser device 1 according to the present embodiment will be described.

In the present embodiment, the insulation film 15a and the metal layer 12L are provided at the end part of the reflection mirror on the DBR layer 12G side as viewed from the active layer 12E. Thus, a laser oscillation at a predetermined oscillation wavelength is generated by the DBR layers 12C and 12G, the insulation film 15a, and the metal layer 12L. At this time, it is possible to generate the laser oscillation at the predetermined oscillation wavelength even in a case where the number of pairs of the DBR layer 12G is less than the number of pairs of the DBR layer 12C. Hence, a resistance at the time of driving is reduced by an amount by which the number of pairs of the DBR layer 12G is reduced. Further, in the surface light-emission laser device 1, the electrode layer 17 is provided in contact with the contact layer 12A that is provided in contact with the DBR layer 12C, and the ring electrode layer 12K separate from the metal layer 12L is provided in contact with the contact layer 12H. Thus, the resistance at the time of driving is reduced as compared with a case where the electrode layer 17 is in contact with the contact layer 12A via an electrically-conductive semiconductor substrate. In addition, it is possible to use an alloy having a low contact resistance as a material of the ring electrode layer 12K. Hence, the resistance at the time of driving becomes small as compared with a case where a non-alloy suitable for a material of the reflection mirror is used as the material of the ring electrode layer 12K. As described above, it is possible for the present embodiment to reduce the resistance at the time of driving. In addition, by providing the ring electrode layer 12K, it is possible to decrease the drive voltage and improve a I-V characteristic.

In addition, in the present embodiment, the metal layer 12L is in contact with the ring electrode layer 12K. Thus, by disposing the bump 14 on the metal layer 12L, it is possible to electrically couple the bump 14 and the ring electrode layer 12K to each other via the metal layer 12L. Hence, it is possible to use the metal layer 12L as a pad electrode for the bump 14 as well, and thereby to increase integration of the emitters 12 as compared with a case where the pad electrode for the bump 14 is provided separately from the metal layer 12L. In addition, by increasing the integration of the emitters 12, it is possible to reduce the resistance caused by drawing of wiring lines.

In addition, in the present embodiment, the insulation film 15a is formed in the opening of the ring electrode layer 12K, and the metal layer 12L is so formed as to block the opening of the ring electrode layer 12K. Thus, in each emitter 12, it is possible to provide the end part (the insulation film 15a and the metal layer 12L) of the reflection mirror on the DBR layer 12G side as viewed from the active layer 12E at a location that faces the light-emission region (or the current injection region 121-1) of the active layer 12E, and it is possible to provide the electric contact with the DBR layer 12G at a location that does not face the light-emission region (or the current injection region 121-1) of the active layer 12E. Hence, it is possible to increase the integration of the emitters 12 as compared with a case where the pad electrode for the bump 14 is provided at a location different from each emitter 12. In addition, by increasing the integration of the emitters 12, it is also possible to reduce the resistance caused by drawing of wiring lines.

In addition, in the present embodiment, the electrode layer 17 is in contact with a position, of the contact layer 12A, that does not face the mesa part 12x. Thus, it is possible to dispose the ring electrode layer 12K on the mesa part 12x and the electrode layer 17 on the contact layer 12A on the side opposite to the light output face of the substrate 13. Hence, it is possible to reduce a space of wiring lines that electrically couple the laser chip 10 and the laser driver IC 20 as compared with a case where the ring electrode layer 12K and the electrode layer 17 are disposed to face each other with the substrate 13 therebetween, and thereby to increase the integration of the emitters 12. In addition, by increasing the integration of the emitters 12, it is also possible to reduce the resistance caused by drawing of wiring lines.

In addition, in the present embodiment, the base section 16 that includes the structure common to the mesa part 12x is provided on the side of the substrate 13 opposite to the light output face, and the coupling layer 19 that electrically couples the electrode layer 18 on the base section 16 and the electrode layer 17 on the contact layer 12A to each other is provided. Thus, electrical coupling of the laser chip 10 and the laser driver IC 20 is facilitated by attaching the laser chip 10 and the laser driver IC 20 to each other via the bump 14. Hence, it is possible to reduce the resistance caused by drawing of wiring lines as compared with a case where the laser chip 10 and the laser driver IC 20 are electrically coupled by a wire bonding or the like. In addition, by forming the coupling layer 19 thick with a plating layer, it is possible to reduce a wiring line resistance of the coupling layer 19.

In addition, in the present embodiment, the laser driver IC 20 is disposed to face a face on the plurality of emitters 12 side of the laser chip 10, and the light emission and the light extinction of each emitter 12 is controlled by the laser driver IC 20 via the plurality of bumps 14, the ring electrode layer 12K of each emitter 12, and the electrode layer 18 on the base section 16. Hence, it is possible to control the light emission and the light extinction of each emitter 12 with a small wiring line resistance.

In addition, in the present embodiment, the DBR layer 12C is configured by the p-type semiconductor, and the DBR layer 12G is configured by the n-type semiconductor. Thus, it is possible to configure the laser driver IC 20 to include the NMOS driver that controls the light emission and the light extinction of each emitter 12. Hence, it is possible to increase a response speed of the laser driver IC 20 as compared with a case where a PMOS driver is used. Accordingly, it is possible to use the surface light-emission laser device 1 suitably for an application that demands a high-speed responsiveness of the driver.

In addition, in the present embodiment, it is possible to suppress the entry of moisture into the mesa part 12x from the outside in a case where the SiN layer in contact with the side face of the mesa part 12x is provided. Hence, it is possible to suppress a deterioration of the mesa part 12x caused by the moisture (for example, an increase in resistance).

### <2. Modification Examples>

Next, modification examples of the surface light-emission laser device 1 according to the embodiment described above will be described.

### [Modification Example A]

FIG. 25 illustrates a modification example of a cross-sectional configuration of the DBR layer 12G in each emitter 12. In the embodiment described above, for example, as illustrated in FIG. 25, the DBR layer 12G may have a low dope layer 12G1 at a position close to the active layer 12E and in which a dope amount is relatively low, and may have a high dope layer 12G2 at a position away from the active layer 12E as compared with the low dope layer 12G1 and in which the dope amount is relatively high. In this case, it is possible to suppress an optical loss caused by a doped impurity to a low level in the vicinity of the active layer 12E in the DBR layer 12G, and to suppress a high resistance at a position away from the active layer 12E in the DBR layer 12G. As described above, in the present modification example, it is possible to achieve both the suppression of the optical loss and the resistance reduction.

### [Modification Example B]

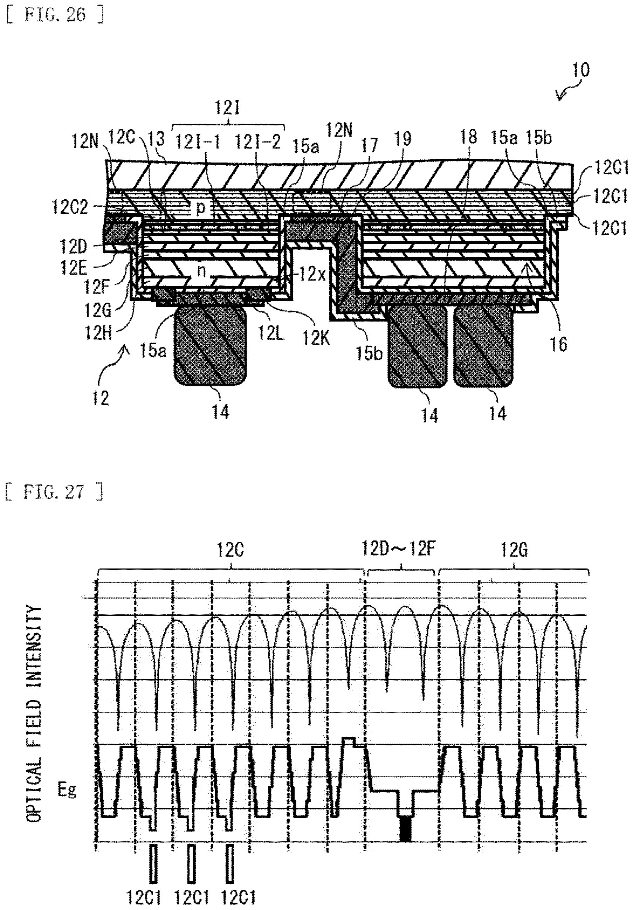

FIG. 26 illustrates a modification example of a cross-sectional configuration of the laser chip 10. In the embodiment described above, a plurality of contact layers 12C1 may be provided instead of the contact layer 12A. At this time, the substrate 13 is provided in contact with the DBR layer 12C. The mesa part 12x includes a portion of the DBR layer 12C. The plurality of contact layers 12C1 is layers for causing each mesa part 12x (specifically, the DBR layer 12C) and the electrode layer 17 to be in ohmic contact with each other. The contact layer 12C1 includes, for example, p-type Alₓ₁Ga₁₋ₓ₁As (0≤x1<1). In this case, it is possible to reduce the resistance at the time of driving by an amount by which the plurality of contact layers 12C1 approaches the active layer 12E.

In the present modification example, the contact layer 12C1 has a role of promoting an electric conduction of a current in a horizontal direction as well as a role as the contact layer. Accordingly, it is preferable that the contact layer 12C1 be doped with a p-type impurity such as carbon at a high concentration (e.g., 2×10¹⁹[1/cm³]). Usually, a layer having a high impurity concentration generates an optical loss. However, in the present modification example, for example, the plurality of contact layers 12C1 is provided at a location where an optical field intensity (a standing wave during resonation) is relatively low as illustrated in FIG. 27. Accordingly, the optical loss caused by each contact layer 12C1 is limited. As described above, in the present modification example, it is possible to achieve both the low resistance and the high light output.

In the present modification example, an etching stop layer 12C2 may be provided instead of the etching stop layer 12B. The etching stop layer 12C2 is provided in the DBR layer 12C, for example, and is in contact with a layer closest to the DBR layer 12C among the plurality of contact layers 12C1. Thus, by using a selective etch by the etching stop layer 12C2 in a manufacturing step, it is possible to ensure that the layer closest to the DBR layer 12C among the plurality of contact layers 12C1 is exposed, and to ensure that the electrode layer 17 comes into contact with the exposed contact layer 12C1.

It should be noted that a region (a contact region 12N) in which an impurity is doped at a high concentration may be provided at a location, of the DBR layer 12C, that faces the electrode layer 17. The contact region 12N is formed by diffusing Zn into a location, of the DBR layer 12C, that faces the electrode layer 17 by using, for example, ion implantation. In this case, it is possible to electrically couple the electrode layer 17 and the contact layer 12C1 to each other at a low resistance. Hence, it is possible to reduce the resistance at the time of driving.

### <3. Application Example>

Hereinafter, an application example of the surface light-emission laser device 1 according to the above-described respective embodiments and modification examples thereof will be described.

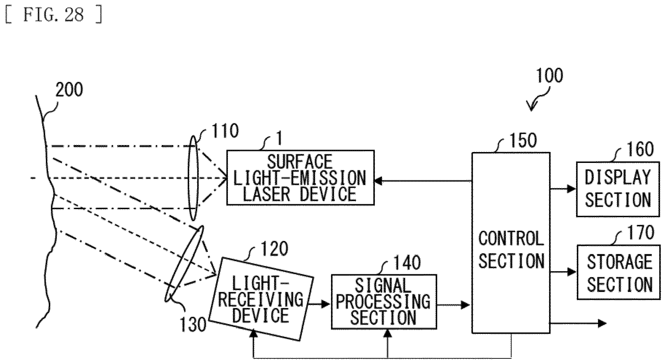

FIG. 28 illustrates an example of a schematic configuration of a distance measuring apparatus 100 provided with the surface light-emission laser device 1. The distance measuring apparatus 100 measures a distance to a detected object 200 by a TOF (Time Of Flight) method. The distance measuring apparatus 100 includes the surface light-emission laser device 1 as a light source. The distance measuring apparatus 100 includes, for example, the surface light-emission laser device 1, a light-receiving device 120, lenses 110 and 130, a signal processing section 140, a control section 150, a display section 160, and a storage section 170.

The light-receiving device 120 detects light reflected by the detected object 200. The lens 110 is a lens for collimating the light outputted from the surface light-emission laser device 1, and is a collimator lens. The lens 130 is a lens for condensing the light reflected by the detected object 200 and guiding the light to the light-receiving device 120, and is a condenser lens.

The signal processing section 140 is a circuit for generating a signal corresponding to a difference between a signal inputted from the light-receiving device 120 and a reference signal inputted from the control section 150. The control section 150 includes, for example, Time to Digital Converter (TDC). The reference signal may be a signal to be inputted from the control section 150, or may be an output signal of a detector that directly detects an output of the surface light-emission laser device 1. The control section 150 is, for example, a processor that controls the surface light-emission laser device 1, the light-receiving device 120, the signal processing section 140, the display section 160, and the storage section 170. The control section 150 is a circuit that measures the distance to the detected object 200 on the basis of the signal generated by the signal processing section 140. The control section 150 generates a picture signal for displaying information on the distance to the detected object 200 and outputs the picture signal to the display section 160. The display section 160 displays the information on the distance to the detected object 200 on the basis of the picture signal inputted from the control section 150. The control section 150 stores, in the storage section 170, the information on the distance to the detected object 200.

In the present application example, the surface light-emission laser device 1 is applied to the distance measuring apparatus 100. Hence, it is possible to use the distance measuring apparatus 100 with low power consumption.

### <4. Applied Example>

### [Applied Example 1]

It is possible to apply a technique according to the present disclosure (the present technology) to a variety of products. For example, the technique according to the present disclosure may be implemented as a device to be mounted on any type of mobile bodies, such as a vehicle, an electric vehicle, a hybrid electric vehicle, a motorcycle, a bicycle, a personal mobility, an airplane, a drone, a vessel, a robot, or the like.

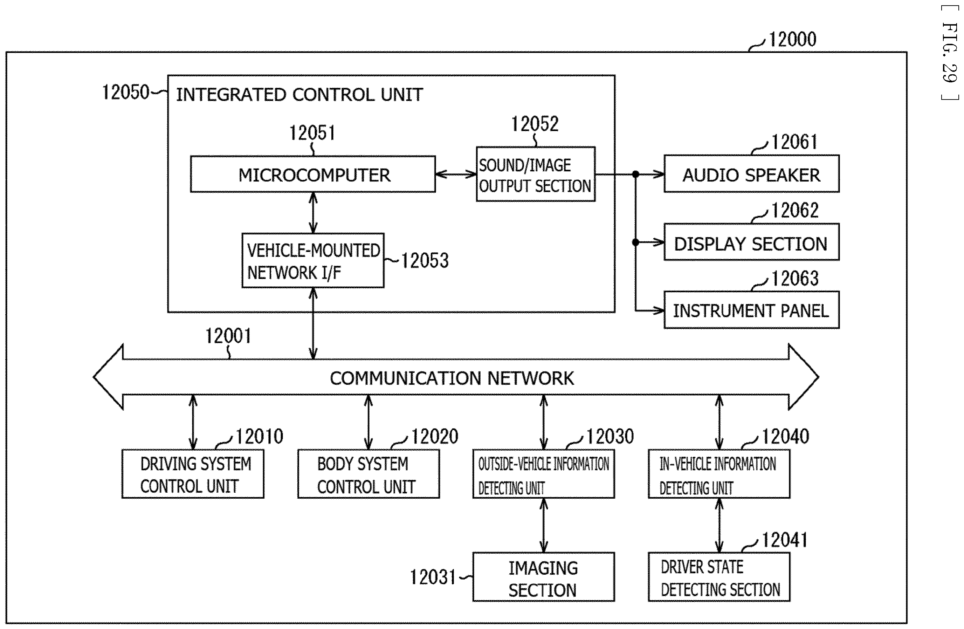

FIG. 29 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 29, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automatic driving, which makes the vehicle to travel autonomously without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 29, an audio speaker 12061, a display section 12062, and an instrument panel 12063 are illustrated as the output device. The display section 12062 may, for example, include at least one of an on-board display and a head-up display.

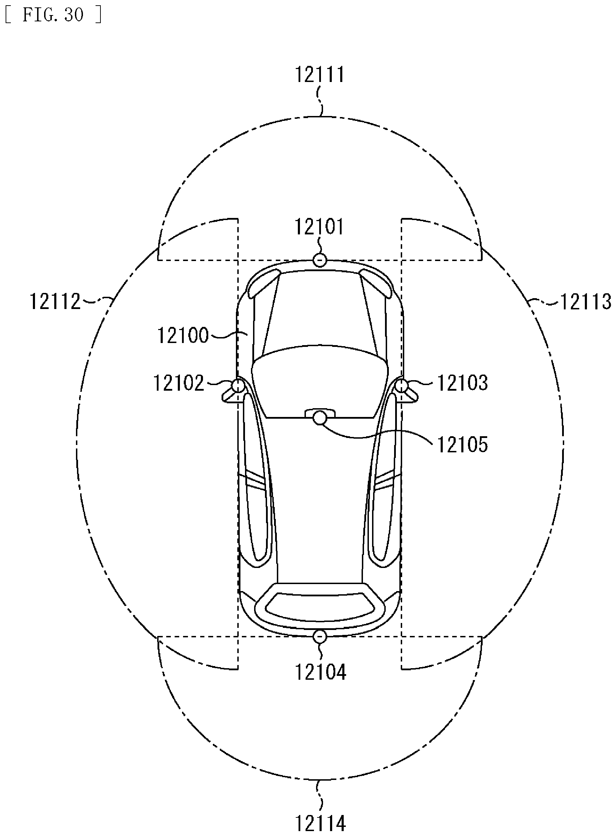

FIG. 30 is a diagram depicting an example of the installation position of the imaging section 12031.

In FIG. 30, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 30 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automatic driving that makes the vehicle travel autonomously without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

An example of the mobile body control system to which the technique according to the present disclosure may be applied has been described above. The technique according to the present disclosure may be applied to the distance measuring apparatus 12031 out of the configurations described above. By applying the technique according to the present disclosure to the distance measuring apparatus 12031, it is possible to use the distance measuring apparatus 12031 with low power consumption.

Although the present disclosure has been described above with reference to the embodiments, the present disclosure is not limited to the above embodiments, and various modifications can be made. It should be noted that the effects described in this specification are only exemplified. The effects of the present disclosure are not limited to the effects described herein. The present disclosure may have effects other than the effects described herein.

For example, the present disclosure may also be configured as follows.
(1) A surface light-emission laser device including:
   an active layer;
   a first DBR (distributed Bragg reflector) layer and a second DBR layer that interpose the active layer therebetween;
   an insulation film and a metal layer that are provided at a position that faces a light-emission region of the active layer, and correspond to an end part of a reflection mirror on the second DBR layer side as viewed from the active layer;
   a first contact layer provided in the first DBR layer or in contact with the first DBR layer;
   a second contact layer provided in contact with the second DBR layer;
   a first electrode layer provided in contact with the first contact layer; and
   a second electrode layer that is in contact with the second contact layer, and provided at a position that does not face the light-emission region of the active layer.
(2) The surface light-emission laser device according to (1), in which
   the metal layer includes a non-alloy, and
   the second electrode layer includes an alloy.
(3) The surface light-emission laser device according to (1) or (2), in which the metal layer is in contact with the second electrode layer.
(4) The surface light-emission laser device according to any one of (1) to (3), in which
   the second electrode layer includes a ring electrode layer having an opening at a position that faces the light-emission region of the active layer,
   the insulation film is formed in the opening of the second electrode layer, and
   the metal layer is formed to block the opening of the second electrode layer.
(5) The surface light-emission laser device according to any one of (1) to (4), in which the number of pairs of the second DBR layer is less than the number of pairs of the first DBR layer.
(6) The surface light-emission laser device according to any one of (1) to (5), further including a mesa part that includes all or a part of the first DBR layer, and that includes the second DBR layer, in which
   the first electrode layer is in contact with a position, of the first contact layer, that does not face the mesa part.
(7) The surface light-emission laser device according to (6), further including a semi-insulating semiconductor substrate provided in contact with a side, of the first DBR layer or the first contact layer, that is opposite to the active layer side, the semiconductor substrate allowing light emitted from the mesa part to transmit therethrough, in which
   the first electrode layer and the second electrode layer are disposed on a side opposite to a light output face of the semiconductor substrate.
(8) The surface light-emission laser device according to (7), further including:
   a base section that includes a structure common to the mesa part on a side opposite to the light output face of the semiconductor substrate;
   a third electrode layer provided on the base section; and
   a coupling layer that electrically couples the first electrode layer and the third electrode layer to each other.
(9) The surface light-emission laser device according to (8), in which the coupling layer includes a plating layer.
(10) The surface light-emission laser device according to (8) or (9), further including:
   a laser chip including a plurality of emitters, the base section, the third electrode, and the coupling layer; and
   a driver IC that faces a face on the plurality of emitters side of the laser chip, in which
   each of the emitters includes the active layer, the first DBR layer, the second DBR layer, the insulation film, the metal layer, the first contact layer, the second contact layer, the first electrode layer, and the second electrode layer, and
   the driver IC is electrically coupled to the second electrode layer of each of the emitters and the third electrode via a plurality of bumps, and controls a light emission and a light extinction of each of the emitters via the plurality of bumps, the second electrode layer of each of the emitters, and the third electrode.
(11) The surface light-emission laser device according to (10), in which
   the first DBR layer is configured by a p-type semiconductor,
   the second DBR layer is configured by an n-type semiconductor, and
   the driver IC includes an NMOS driver that controls the light emission and the light extinction of each of the emitters.
(12) The surface light-emission laser device according to any one of (6) to (11), further including a SiN layer that is in contact with a side face of the mesa part.
(13) The surface light-emission laser device according to any one of (6) to (12), further including an etching stop layer that is provided in the mesa part and in contact with the first contact layer.
(14) The surface light-emission laser device according to any one of (6) to (13), in which the second DBR layer includes a low dope layer at a position close to the active layer and in which a dope amount is relatively low, and a high dope layer at a position away from the active layer as compared with the low dope layer and in which a dope amount is relatively high.
(15) The surface light-emission laser device according to any one of (1) to (14), in which the first contact layer is provided at a location that is in the first DBR layer and where an optical field intensity is relatively low.
(16) The surface light-emission laser device according to any one of (6) to (15), in which the insulation film includes a stacked body in which two or three sets of a pair of Si and SiO₂ are stacked.

In the surface light-emission laser device according to one embodiment of the present disclosure, the insulation film and the metal layer are provided at the end part of the reflection mirror on the second DBR layer side as viewed from the active layer, the first electrode layer is provided in contact with the first contact layer provided in the first DBR layer or in contact with the first DBR layer, and the second electrode layer separate from the metal layer is provided in contact with the second contact layer. Hence, it is possible to reduce the resistance at the time of driving. It should be noted that the effects of the present disclosure are not necessarily limited to the effect described here, and may be any of the effects described in the present specification.

The present application claims the benefit of Japanese Priority Patent Application JP2019-201616 filed with the Japan Patent Office on November 6, 2019 and Japanese Priority Patent Application JP2020-064016 filed with the Japan Patent Office on March 31, 2020, the entire contents of which are incorporated herein by reference.

It should be understood by those skilled in the art that various modifications, combinations, sub-combinations and alterations may occur depending on design requirements and other factors insofar as they are within the scope of the appended claims or the equivalents thereof.

## Claims

1. A surface light-emission laser device comprising:
an active layer;
a first DBR (distributed Bragg reflector) layer and a second DBR layer that interpose the active layer therebetween;
an insulation film and a metal layer that are provided at a position that faces a light-emission region of the active layer, and correspond to an end part of a reflection mirror on the second DBR layer side as viewed from the active layer;
a first contact layer provided in the first DBR layer or in contact with the first DBR layer;
a second contact layer provided in contact with the second DBR layer;
a first electrode layer provided in contact with the first contact layer; and
a second electrode layer that is in contact with the second contact layer, and provided at a position that does not face the light-emission region of the active layer.

2. The surface light-emission laser device according to claim 1, wherein
the metal layer includes a non-alloy, and
the second electrode layer includes an alloy.

3. The surface light-emission laser device according to claim 2, wherein the metal layer is in contact with the second electrode layer.

4. The surface light-emission laser device according to claim 3, wherein
the second electrode layer comprises a ring electrode layer having an opening at a position that faces the light-emission region of the active layer,
the insulation film is formed in the opening of the second electrode layer, and
the metal layer is formed to block the opening of the second electrode layer.

5. The surface light-emission laser device according to claim 1, wherein the number of pairs of the second DBR layer is less than the number of pairs of the first DBR layer.

6. The surface light-emission laser device according to claim 1, further comprising a mesa part that includes all or a part of the first DBR layer, and that includes the second DBR layer, wherein
the first electrode layer is in contact with a position, of the first contact layer, that does not face the mesa part.

7. The surface light-emission laser device according to claim 6, further comprising a semi-insulating semiconductor substrate provided in contact with a side, of the first DBR layer or the first contact layer, that is opposite to the active layer side, the semiconductor substrate allowing light emitted from the mesa part to transmit therethrough, wherein
the first electrode layer and the second electrode layer are disposed on a side opposite to a light output face of the semiconductor substrate.

8. The surface light-emission laser device according to claim 7, further comprising:
a base section that includes a structure common to the mesa part on a side opposite to the light output face of the semiconductor substrate;
a third electrode layer provided on the base section; and
a coupling layer that electrically couples the first electrode layer and the third electrode layer to each other.

9. The surface light-emission laser device according to claim 8, wherein the coupling layer comprises a plating layer.

10. The surface light-emission laser device according to claim 8, further comprising:
a laser chip including a plurality of emitters, the base section, the third electrode, and the coupling layer; and
a driver IC that faces a face on the plurality of emitters side of the laser chip, wherein
each of the emitters includes the active layer, the first DBR layer, the second DBR layer, the insulation film, the metal layer, the first contact layer, the second contact layer, the first electrode layer, and the second electrode layer, and
the driver IC is electrically coupled to the second electrode layer of each of the emitters and the third electrode via a plurality of bumps, and controls a light emission and a light extinction of each of the emitters via the plurality of bumps, the second electrode layer of each of the emitters, and the third electrode.

11. The surface light-emission laser device according to claim 10, wherein
the first DBR layer is configured by a p-type semiconductor,
the second DBR layer is configured by an n-type semiconductor, and
the driver IC includes an NMOS driver that controls the light emission and the light extinction of each of the emitters.

12. The surface light-emission laser device according to claim 6, further comprising a SiN layer that is in contact with a side face of the mesa part.

13. The surface light-emission laser device according to claim 6, further comprising an etching stop layer that is provided in the mesa part and in contact with the first contact layer.

14. The surface light-emission laser device according to claim 6, wherein the second DBR layer includes a low dope layer at a position close to the active layer and in which a dope amount is relatively low, and a high dope layer at a position away from the active layer as compared with the low dope layer and in which a dope amount is relatively high.

15. The surface light-emission laser device according to claim 1, wherein the first contact layer is provided at a location that is in the first DBR layer and where an optical field intensity is relatively low.

16. The surface light-emission laser device according to claim 6, wherein the insulation film includes a stacked body in which two or three sets of a pair of Si and SiO₂ are stacked.
